# EUROPEAN PATENT SPECIFICATION

(11) **EP 2 793 319 B1**
(45) Date of publication and mention of the grant of the patent: **21.06.2017**
(21) Application number: 12857877.0
(22) Date of filing: 12.12.2012
(51) Int. Cl.: H01R 13/73, H01R 24/38, H05K 9/00, H01R 13/6582, H01R 24/52, H02J 5/00

(54) **STRUCTURE FOR FIXING ELECTRICAL CONNECTION SECTION, CONNECTOR, AND METHOD FOR CONNECTING CONNECTOR**
BEFESTIGUNGSSTRUKTUR FÜR ELEKTRISCHEN VERBINDUNGSABSCHNITT, VERBINDER UND VERFAHREN ZUM ANSCHLUSS VON VERBINDERN
STRUCTURE SERVANT À FIXER UNE SECTION DE CONNEXION ÉLECTRIQUE, CONNECTEUR, ET PROCÉDÉ DE CONNEXION DE CONNECTEUR

(30) Priority: 13.12.2011 JP 2011271843; 12.03.2012 JP 2012054402; 12.03.2012 JP 2012054437
(43) Date of publication of application: 22.10.2014
(73) Proprietor: Yazaki Corporation, Minato-ku Tokyo 108-8333 (JP)
(72) Inventor: NAGASHIMA, Yoshikazu, Susono-shi Shizuoka 410-1194 (JP)
(74) Representative: Grünecker Patent- und Rechtsanwälte PartG mbB
(86) International application number: PCT/JP2012/082261
(87) International publication number: WO 2013/089160

(56) References cited:
- WO-A1-2012/144637
- WO-A1-2012/144640
- JP-A- H0 855 654
- JP-A- H05 217 635
- JP-A- H09 289 723
- JP-A- H10 241 792
- JP-A- 2008 153 225
- JP-A- 2012 089 332
- JP-U- 3 024 770
- JP-U- H04 102 171
- US-A1- 2003 062 177

## Description

### Technical field

The present invention relates to a connector, particularly to a structure for fixing an electrical connection section where the connector is used, and a method for connecting the connector.

### Background art

JP H09 289723 A discloses a structure for fixing an electrical connection section according to the preamble of claim 1.
JP 2012 089332 A discloses a connector which is capable of preventing water entry into an apparatus.
JP H10 241792 A discloses a electromagnetic structure which comprises a wire that is connected to a mounting member via connector.
US 2003/062177 A1 discloses a electromagnetic shielding structure for electric wire.

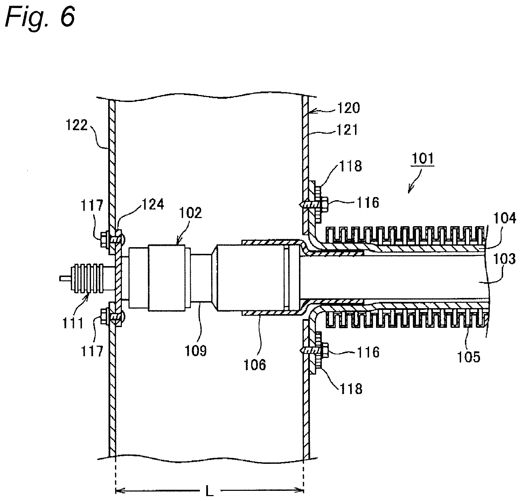

In a contactless power supply system (for example, refers to a patent document 1.) which is proposed as an example by the applicant of the present application, as shown in Fig. 6, a structure for fixing an electrical connection section is adopted to connect and fix an electrical connection section 102 of a shielded electric wire 101 to an electrical connection section 111 of a shield housing 120.

### Citation List

### Patent documents

Patent document 1: Japanese Patent Application No. 2011-96365

### Summary of Invention

### Technical Problem

However, for the structure for fixing the electrical connection section proposed by the applicant of the application, an interval L between an inside shield 122 and an outside shield 121 is wider than the electrical connection section 102 to prevent a short-circuit due to a contact of the conductive electrical connection section 102 and the outside shield 121. Therefore, when the electrical connection section 102 of the shielded electric wire 101 is connected to the electrical connection section 111 of the shield housing 120, the operation of connecting the electrical connection sections 102, 111 has to be performed in the interval between the inside shield 122 and the outside shield 121.

Further, because a shield member 104 is fixed to the outside shield 121 by a fastening bracket 118, an operation of aligning the shield member 104 and the fastening bracket 118 to the outside shield 121 has to be performed.

Thus, because the operation of connecting and fixing the electrical connection section 102 of the shielded electric wire 101 to the electrical connection section 111 of the shield housing 120 becomes complicated, there is now a demand for an operability improvement.

The present invention is made in view of the above circumstances. That is, an object of the present invention is to provide an electrical connecting part fixing structure, a connector, and a method for connecting the connector so that the operation of connecting an electrical connection section which the terminal of an shielded electric wire is provided with and an electrical connection section which a shielded device is provided with can be improved.

### Solution to Problem

In order to solve the problem to achieve the object, according to the present invention, there is provided a structure for fixing an electrical connection section which connects and fixes an electrical connection section of a shielded electric wire to an electrical connection section of a shield housing, the structure comprising:
an electrically insulative annular member which is provided slidably along an outer peripheral surface of the electrical connection section of the shielded electric wire;
a conductive fixing member which is provided on the outer peripheral surface of the annular member and is fixed to the shield housing; and
a shield member which covers the electric wire and is mechanically connected to the fixing member, wherein
the fixing member is conductive;
   the shield member covers the electric wire and is electrically connected to the fixing member, and
   the shield member is bent with sliding of the annular member.

Further, in the structure for fixing the electrical connection section according to the present invention, the fixing member is provided with a protective cover which is electrically insulative and waterproof, and the protective cover is bent with sliding of the annular member.

Further, in the structure for fixing the electrical connection section according to the present invention, the fixing member is provided with a locking part which is locked to the protective cover, and the protective cover is configured to be attachable to and detachable from the locking part.

Further, according to the present invention, there is provided an assembly according to claim 4.

Further, according to the present invention, there is provided a method for connecting a connector, which is used in a assembly according to claim 4, wherein the annular member is slid towards a longitudinally intermediate part of the electric wire so that the shield member is bent and the electrical connection section is projected,
the electrical connection section of the shielded electric wire is fitted and mechanically and electrically connected to the electrical connection section of the shield housing,
the annular member is slid towards an end of the electrical connection section of the shielded electric wire so that the shield member is restored to an initial shape, and
the fixing member is mechanically and electrically connected and fixed to the shield housing.

According to the structure for fixing the electrical connection section of the present invention, the shield housing can be insulated from the electrical connection section of the shielded electric wire by the annular member, and because when the annular member is slid towards the longitudinally intermediate part of the electric wire, the shield member is bent and the electrical connection section of the shielded electric wire is projected, it is possible to connect the electrical connection section of the shielded electric wire to the electrical connection section of the shield housing from the outside of the shield housing. Therefore, the operability of the connecting operation can be improved.

Because the shield member which is connected to the fixing member is bent with the slide of the annular member, only by mechanically and electrically connecting the fixing member to the shield housing, the shield member can be fixed to the shield housing through the fixing member, and the operability of the fixing operation can be improved.

Thus, while the operability of connecting the electrical connection section of the shielded electric wire can be improved, because the operability of fixing the shield member can be improved, the operability when the electrical connection section of the shielded electric wire is connected to the shield housing can be improved.

According to the structure for fixing the electrical connection section of the present invention, while the fixing member can be electrically insulated from the outside, the invasion of water from the outside can be prevented.

According to the structure for fixing the electrical connection section of the present invention, because the protective cover can be attached/detached to/from the fixing member, when the shield member is fixed to the shield housing through the fixing member, it is possible to remove the protective cover to fix the fixing member and the shield housing, and the protective cover can be attached to the fixing member after the fixing operation is completed. Therefore, an operability drop of the operation of fixing the fixing member can be prevented.

According to the connector of the present invention, while the operability of connecting the electrical connection section can be improved, the operability of fixing the shield member can be improved. Thus, the operability when the connector is connected to the electrical connection section of the shield housing can be improved.

According to the connector connecting method of the present invention, the annular member is slid towards the longitudinally intermediate part of the electric wire so that the shield member is bent and the electrical connection section is projected, the electrical connection section of the shielded electric wire is fitted and mechanically and electrically connected to the electrical connection section of the shield housing, the annular member is slid towards the end of the electrical connection section of the shielded electric wire so that the shield member is restored to an initial shape, and the fixing member is mechanically and electrically connected and fixed to the shield housing. Thus, the connector can be connected to the electrical connection section of the shield housing with a simple operation, and the operability of the connecting operation becomes better.

Further, according to another embodiment of the present invention, there is provided a connector comprising:
a cable side connector which is connected to a two-layer coaxial wire having an inside shielding layer and an outside shielding layer while a coaxial structure is maintained; and
a unit side connector which is connected to the cable side connector while the coaxial structure is maintained and which is connected to a unit which has a shielded structure, wherein
the unit side connector includes
   an outside connector, which electrically connects the outside shielding layer to an outside shielding case, and which is connected to the cable side connector, and
   an inside connector, which electrically connects the inside shielding layer to an inside shielding case, which is connected to the outside connector, and which is able to be connected to an internal device which is placed inside the inside shielding case so as to be electrically connected to an intermediate conductor of the coaxial wire.

According to this embodiment of the invention, a technique to remarkably improve the workability in the setting place, where a transmission wire of a two-layer shield structure is set, can be provided.

Further, according to another embodiment of the present invention, there is provided a connector comprising:
a cable side connector which is connected to a two-layer coaxial wire having an inside shielding layer and an outside shielding layer while a coaxial structure is maintained; and
a unit side connector which is connected to the cable side connector while the coaxial structure is maintained and which is connected to a unit which has a shielded structure, wherein
the unit side connector has a substantially columnar connector body wherein one end of the connector body is connected to the cable side connector and the other end of the connector body is connected to the unit, and a sliding part which covers an outer periphery of the connector body and is arranged movably back and forth in an axial direction,
the connector body is configured to electrically connect and fix an inner conductor, which is electrically connected to the inside shielding layer of the coaxial wire, to an inside shielding case which covers the unit, and
the sliding part includes a slide side intermediate conductor which is electrically connected to a body side intermediate conductor, which is electrically connected to the outside shielding layer of the coaxial wire, of the connector body when the sliding part moves, and is configured to electrically connect and fix the slide side intermediate conductor to an outside shielding case which is placed outside the inside shielding case.

According to this embodiment of the invention, a technique to remarkably improve the workability in the setting place, where a transmission wire of a two-layer shield structure is set, can be provided.

### Advantageous Effects of Invention

According to the present invention, the operation of connecting an electrical connection section which the terminal of an shielded electric wire is provided with and an electrical connection section which a shielded device is provided with can be improved.

### Brief Description of Drawings

[Fig. 1] Fig. 1 is a schematic block diagram to describe a resonance-type contactless power supply system which includes a connector according to one embodiment of the present invention.
[Fig. 2] Fig. 2 is a sectional view to describe the construction of the connector according to the embodiment of the present invention.
[Fig. 3] Fig. 3 is a sectional view of the connector taken along a line indicated by III-III shown in Fig. 2.
[Fig. 4] Fig. 4 is a sectional view to describe an operation of connecting the connector according to the embodiment of the present invention with a transmission coil part.
[Fig. 5] Fig. 5 is a sectional view which shows that the connector according to the embodiment of the present invention and the transmission coil part are connected.
[Fig. 6] Fig. 6 is a sectional view which shows that a traditional transmission side coaxial connector and a transmission coil part are connected.
[Fig. 7] Fig. 7 is a figure which shows the profile of a resonance-type contactless power supply system according to the background art.
[Fig. 8] Fig. 8 is a figure which shows the connecting structure of a connector in the resonance-type contactless power supply system according to the background art.
[Fig. 9] Fig. 9 is a figure of the connecting structure of a transmission wire (coaxial wire) and the connector according to an embodiment.
[Fig. 10] Figs. 10A and 10B are figures which show that a unit side connector is connected to a shielding case according to the embodiment.
[Fig. 11] Figs. 11A and 11B are figures which show examples of the unit side connector, in which the length of an inside connector varies, according to the embodiment.
[Fig. 12] Fig. 12 is a figure which shows that the unit side connector is connected when there is one shielding case according to the embodiment.
[Fig. 13] Fig. 13 is a figure which shows the profile of a resonance-type contactless power supply system according to the background art.
[Fig. 14] Fig. 14 is a figure which shows the connecting structure of a connector in the resonance-type contactless power supply system according to the background art.
[Fig. 15] Fig. 15 is a figure of the connecting structure of a transmission wire (coaxial wire) and the connector according to an embodiment.
[Fig. 16] Figs. 16A and 16B are figures which show that a unit side connector is connected to a shielding case according to the embodiment.
[Fig. 17] Figs. 17A and 17B are figures which show examples of the unit side connector, in which the distance between an outside shielding case and an inside shielding case varies, according to the embodiment.
[Fig. 18] Fig. 18 is a figure which shows a unit side connector according to a variation of the embodiment.

### Description of Embodiments

Below, embodiments of the invention are described with reference to the attached figures. The embodiments to be described below are only representative embodiments of the invention, and the invention is not limited to these embodiments. Therefore, the present invention can be modified and carried out in a range without departing from the spirit of the present invention, that is, a range which those skilled in the art can assume easily, substantially the same range, or a so-called equivalent range.

### (First embodiment)

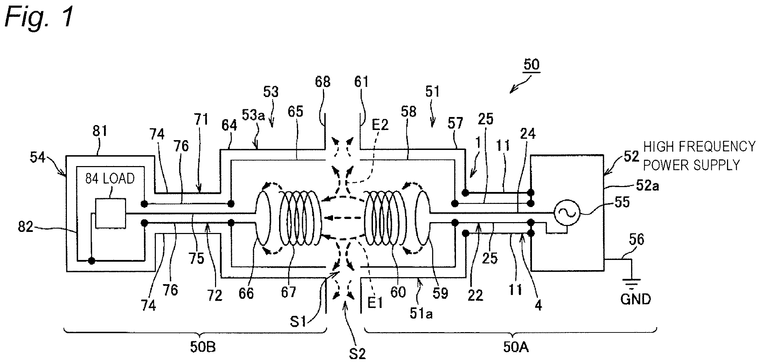

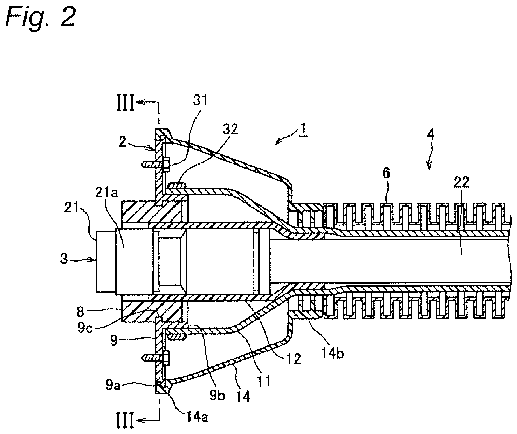

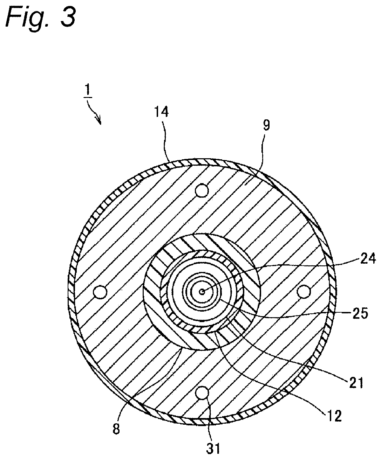

Fig. 1 is a schematic block diagram of a resonance-type contactless power supply system 50 which includes a connector 1 according to one embodiment of the present invention. Fig. 2 is a sectional view of the connector 1 according to the embodiment of the present invention. Fig. 3 is a sectional view, taken along a line indicated by III-III lines, of the connector 1 according to embodiment of the present invention.

As shown in Fig. 1, the connector 1 according to the embodiment of the present invention is provided at one terminal of a transmission side transmission cable 4 which is to supply high frequency power that is output from a high frequency power source 52 to a transmission coil part 51 in the resonance-type contactless power supply system 50.

For example, the resonance-type contactless power supply system 50 is applied to the power supply system in an electric car or the like. As shown in Fig. 1, the resonance-type contactless power supply system 50 includes a transmission side device 50A and a receiving side device 50B.

For example, the transmission side device 50A is buried under the parking lot, for example, of a house or a public accommodation. The transmission side device 50A includes the high frequency power source 52 which outputs high frequency power and the transmission coil part 51 which produces an electromagnetic field E1. The high frequency power source 52 and the transmission coil part 51 are connected by the transmission side transmission cable 4 whose one terminal is provided with the connector 1.

The high frequency power source 52 includes a housing shield 52a which is a housing, a high frequency oscillation source 55 which is incorporated in the housing shield 52a, and a power source cable FG line 56 which grounds the housing shield 52a to a ground GND.

An inner conductor 24 of the transmission side coaxial cable 22, which is the electric wire of the transmission side transmission cable 4, is connected to the high frequency oscillation source 55. An outer conductor 25 of the transmission side coaxial cable 22 and a transmission side coaxial cable shield 11, which is a shield member that covers the transmission side coaxial cable 22, are connected to the housing shield 52a. The high frequency oscillation source 55 is so configured so that, for example, power of 1-3kW whose frequency is in a range of 10-16MHz is output.

The transmission side coaxial cable 22 includes the inner conductor 24, an insulator which covers the outer peripheral surface of the inner conductor 24, the outer conductor 25 which is provided around the outer peripheral surface of the insulator, and a sheath which covers the outer peripheral surface of the outer conductor 25. A corrugated tube 6, which is a protector having insulation property and waterproofness, is fitted around the transmission side coaxial cable 22.

The inner conductor 24 is manufactured of a conducting wire made of conductive metal such as copper, copper alloy, aluminum or aluminum alloy. One end of the inner conductor 24 is connected to the high frequency oscillation source 55 of the high frequency power source 52, and the other end of the inner conductor 24 is connected to a coaxial connector 3 which is an electrical connection section of the connector 1. The insulator that covers the inner conductor 24 is formed of synthetic resin such as polyethylene resin.

The outer conductor 25 is manufactured of a hollow, circular web wire made of conductive metal such as copper, copper alloy, aluminum or aluminum alloy. One end of the outer conductor 25 is mechanically and electrically connected to the housing shield 52a of the high frequency power source 52 and the other end of the high frequency oscillation source 55, and the other end of the outer conductor 25 is connected to the coaxial connector 3. The sheath that covers the outer conductor 25 is formed of synthetic resin such as vinyl chloride resin.

The transmission side coaxial cable shield 11 is manufactured of a hollow, circular web wire made of conductive metal such as copper, copper alloy, aluminum or aluminum alloy. One end of the transmission side coaxial cable shield 11 is mechanically and electrically connected to the housing shield 52a of the high frequency power source 52, and as shown in Fig. 2, the other end of the transmission side coaxial cable shield 11 is mechanically and electrically connected to a fixing member 9 of the connector 1.

As shown in Fig. 1, the transmission coil part 51 includes a primary coil 59 which produces the electromagnetic field E1 due to the high frequency power that is output from the high frequency power source 52, a primary resonance coil 60 which is magnetically coupled to the primary coil 59, and a shield housing 51 a.

The shield housing 51 a includes an inside shield 58 which covers the primary coil 59 and the primary resonance coil 60 from outside, and an outside shield 57 which covers the inside shield 58 from outside.

The inside shield 58 is manufactured of good conductor metal such as iron or copper, and is formed into a bottomed barrel shape which opens at one side. The inside shield 58 completely covers the primary coil 59 and the primary resonance coil 60 except the opening.

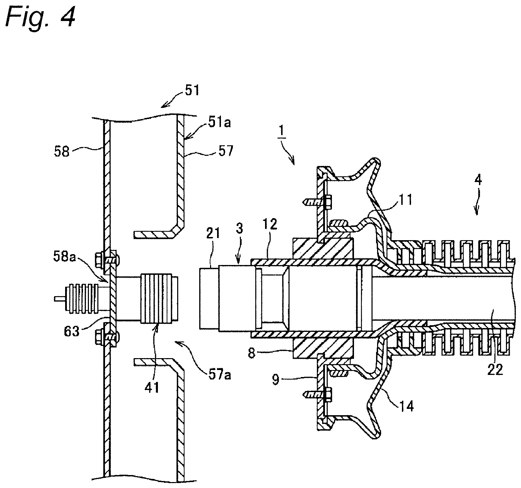

As shown in Fig. 4, the bottom surface part of the inside shield 58 is provided with a relay connector 41, which is an electrical connection section of the shield housing, an opening 58 into which the relay connector 41 is inserted, and a fixing board 63 which blocks up the opening 58a and fixes the relay connector 41 to the bottom surface part.

The relay connector 41 is named as a so-called receptacle, and, for example, includes a cylindrical outer conductor around which an outer terminal metal fitting of the coaxial connector 3 to be described below is fitted to be electrically connected, a central conductor to which an inner terminal metal fitting of the coaxial connector 3 is press-fitted to be electrically connected, and an insulator which insulates the outer conductor from the central conductor. The outer peripheral surface of the outer conductor is provided with a screw thread or a plurality of grooves.

The outside shield 57 is manufactured of good conductor metal such as iron or copper, and is formed into a bottomed barrel shape which opens at one side. As shown in Fig. 1, the edge part of the opening of the outside shield 57 is provided with a flange 61 to suppress the emission of an emission electromagnetic field E2 to the outside. The outside shield 57 completely covers the inside shield 58 except the opening.

As shown in Fig. 4, the bottom surface part of the outside shield 57 is provided with an opening 57a through which the coaxial connector 3, as the electrical connection section of the connector 1, is inserted. The edge part of the opening 57a is bent towards the inside shield 58. The opening 57a is formed into a circular shape along the external shape of an annular member 8 of the connector 1 to be described below.

The receiving side device 50B is, for example, carried in a vehicle such as an electric car. As shown in Fig. 1, the receiving side device 50B includes a power receiving coil part 53 and a load device 54 which charges, for example, the battery of, for example, an electric car. The power receiving coil part 53 and the load device 54 are connected by a receiving side transmission cable 71 which includes a receiving side coaxial cable 72 and a receiving side coaxial cable shield 74.

The receiving side coaxial cable 72 includes an inner conductor 75, an insulator which covers the outer peripheral surface of the inner conductor 75, an outer conductor 76 which is provided around the outer peripheral surface of the insulator, and a sheath which covers the outer peripheral surface of the outer conductor 76.

One end of the inner conductor 75 is connected to one end of a secondary coil 66, and the other end of the inner conductor 75 is connected to a load 84. One end of the outer conductor 76 is mechanically and electrically connected to an inside shield 65 of the power receiving coil part 53 and the other end of the secondary coil 66, and the other end of the outer conductor 76 is mechanically and electrically connected to an inside shield 82 of the load device 54.

The receiving side coaxial cable shield 74 is made of conductive metal such as copper, copper alloy, aluminum or aluminum alloy, and is manufactured of a hollow, circular web wire. One end of the receiving side coaxial cable shield 74 is mechanically and electrically connected to an outside shield 64 of the power receiving coil part 53, and the other end of the receiving side coaxial cable shield 74 is mechanically and electrically connected to an outside shield 81 of the load device 54.

The power receiving coil part 53 includes a secondary resonance coil 67 which resonates with the primary resonance coil 60, and a secondary coil 66 which is magnetically coupled to the secondary resonance coil 67, and a shield housing 53a.

The shield housing 53a includes the inside shield 65 which covers the secondary resonance coil 67 and the secondary coil 66 from outside, and the outside shield 64 which covers the inside shield 65 from outside.

The inside shield 65 is manufactured of good conductor metal such as iron or copper, and is formed into a bottomed barrel shape which opens at one side. The inside shield 65 completely covers the secondary resonance coil 67 and the secondary coil 66 except the opening.

The bottom surface part of the inside shield 65 is provided with an opening through which the inner conductor 75 of the receiving side coaxial cable 72 is inserted. One end of the outer conductor of the receiving side coaxial cable 72 is mechanically and electrically connected to the edge part of the opening.

The outside shield 64 is manufactured of good conductor metal such as iron or copper, and is formed into a bottomed barrel shape which opens at one side. The edge part of the opening of the outside shield 64 is provided with a flange 68 to suppress the emission of an emission electromagnetic field E2 to the outside. The outside shield 64 completely covers the inside shield 65 except the opening.

The bottom surface part of the outside shield 64 is provided with an opening through which the receiving side coaxial cable 72 is inserted. One end of the receiving side coaxial cable shield 74 is mechanically and electrically connected to the edge part of the opening.

The load device 54 includes the load 84 such as the battery, the inside shield 82 which covers the load 84 from outside, and the outside shield 81 which covers the inside shield 82 from outside. The other end of the inner conductor 75 of the receiving side coaxial cable 72 is connected to the load 84.

The inside shield 82 is formed of good conductor metal such as iron or copper.
The inside shield 82 is provided with an opening through which the inner conductor 75 of the receiving side coaxial cable 72 is inserted, and the load 84 is electrically connected to the inside shield 82.

The other end of the outer conductor 76 of the receiving side coaxial cable 72 is mechanically and electrically connected to the edge part of the opening of the inside shield 82. The inside shield 82 completely covers the load 84 except the opening.

The outside shield 81 is formed of good conductor metal such as iron or copper. The outside shield 81 is provided with an opening through which the receiving side coaxial cable 72 is inserted.

The other end of the receiving side coaxial cable shield 74 is mechanically and electrically connected to the edge part of the opening of the outside shield 81. The outside shield 81 completely covers the inside shield 82 except the opening.

As shown in Figs. 1 and 2, the connector 1 includes the coaxial connector 3 as the electrical connection section of the shielded electric wire and a connector fixing device 2 as a structure for fixing an electrical connection section. The connector 1 is provided at one terminal of the transmission side transmission cable 4, and is fixed to the transmission coil part 51.

The coaxial connector 3 is, for example, a so-called HN connector, and includes a plug 21 which is connected to a terminal of the transmission side coaxial cable 22. For example, the plug 21 includes a sleeve which is crimped to the terminal of the transmission side coaxial cable 22, an inner terminal metal fitting which is electrically connected to the inner conductor 24 of the transmission side coaxial cable 22, and an outer terminal metal fitting which is electrically connected to the outer conductor 25 of the transmission side coaxial cable 22. Part of the outer peripheral surface of the plug 21 where the plug is screwed to the relay connector 41 is provided with a slip-resistant part 21 a where a plurality of ditches which intersect each other are formed into a mesh form.

The connector fixing device 2 is provided at the terminal of the transmission side transmission cable 4. The connector fixing device 2 includes the annular member 8, the fixing member 9, a transmission side coaxial cable shield 11 and a protective cover 14.

The annular member 8 is provided along the outer peripheral surface of the coaxial connector 3 to be slidable in the axial direction of the coaxial connector 3. The annular member 8 is formed into a cylindrical shape along the external shape of the coaxial connector 3, and is formed of synthetic resin which has electric insulation property.

As shown in Figs. 2 and 3, the fixing member 9 is provided at the outer peripheral surface of the annular member 8, and is formed into an annular disk shape. The inter peripheral part of the fixing member 9 is provided with a connecting part 9c to which the other end of the transmission side coaxial cable shield 11 is mechanically and electrically connected, and an engaging part 9b which engages with the outer peripheral surface of the annular member 8.

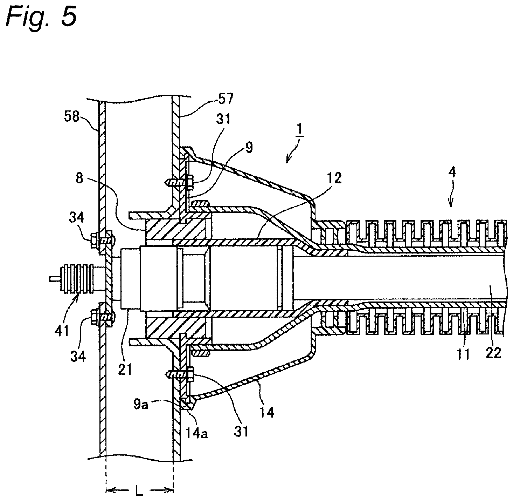

The outer peripheral part of the fixing member 9 is provided with a locking part 9a which is locked in a locking groove 14a of the protective cover 14. The connecting part 9b of the fixing member 9 and the other end of the transmission side coaxial cable shield 11 are fixed and connected by a crimping ring 32. As shown in Fig. 5, the fixing member 9 is fixed to the outside shield 57 of the housing of the transmission coil part 51 by bolts 31.

The transmission side coaxial cable shield 11 is manufactured of a hollow, circular web wire made of conductive metal such as copper, copper alloy, aluminum or aluminum alloy. As shown in Fig. 4, the transmission side coaxial cable shield 11 is formed to be flexible with the slide of the annular member 8.

As shown in Figs. 2 and 3, the protective cover 14 includes the locking groove 14a in which the locking part 9a of the fixing member 9 is locked, and an insertion part 14b through which the transmission side transmission cable 4 is inserted. As shown in Fig. 4, the protective cover 14 is formed to be flexible with the slide of the annular member 8.

Next, with reference to Figs. 4 and 5, the connection of the connector 1 according to the embodiment of the present invention as configured above with the transmission coil part 51 is described.

As shown in Fig. 4, with the slide of the annular member 8 towards the longitudinally intermediate part of the transmission side coaxial cable 22 and each of the transmission side coaxial cable shield 11 and the protective cover 14 is bent and deformed, the coaxial connector 3 is projected from the annular member 8.

Then, while the coaxial connector 3 is fitted to and mechanically and electrically connected to the relay connector 41, the annular member 8 is slid to the end side of the coaxial connector 3, and the fixing member 9 abuts against the outside shield 57 of the transmission coil part 51, each of the transmission side coaxial cable shield 11 and the protective cover 14 is restored to the original shape.

Then, the locking groove 14a of the protective cover 14 is removed from the locking part 9a of the fixing member 9, the bolts 31 are operated from outside to mechanically and electrically connect and fix the fixing member 9 to the outside shield 57, and the locking part 9a is locked in the locking groove 14a, as shown in Fig. 5. In this way, the connector 1 according to the embodiment of the present invention is mechanically and electrically connected and fixed to the transmission coil part 51.

As described above, the connector fixing device 2 according to the embodiment of the present invention is an electrical connecting part fixing structure, which connects and fixes the coaxial connector 3 of the transmission side coaxial cable 22 to the relay connector 41 of the inside shield 58. Further, the connector fixing device 2 includes the electrically insulative annular member 8 which is provided slidably along the outer peripheral surface of the coaxial connector 3, the conductive fixing member 9 which is provided around the outer peripheral surface of the annular member 8 and fixed to the shield housing 51 a, and the transmission side coaxial cable shield 11 which covers the transmission side coaxial cable 22 and is mechanically and electrically connected to the fixing member 9, and the transmission side coaxial cable shield 11 is bent with the slide of the annular member 8.

According to the connector fixing device 2 of the embodiment of the present invention as configured above, the coaxial connector 3 and the outside shield 57 of the shield housing 51a can be insulated by the annular member 8, and the coaxial connector 3 is projected while the transmission side coaxial cable shield 11 is bent in the sliding direction of the annular member 8 when the annular member 8 is slid towards the longitudinally intermediate part of the transmission side coaxial cable 22. Thus, as shown in Fig. 5, the plug 21 and the outside shield 57 are electrically insulated by the annular member 8, and the interval L between the inside shield 58 and the outside shield 57 can be reduced. Further, as shown in Fig. 4, the operation of connecting the coaxial connector 3 to the relay connector 41 from the outside of the outside shield 57 of the shield housing 51 a of transmission coil part 51 can be performed, and the operability of the connecting operation can be improved.

Because the transmission side coaxial cable shield 11 connected to the fixing member 9 is bent with the slide of the annular member 8, only by mechanically and electrically connecting the fixing member 9 to the outside shield 57 of the shield housing 51a, the transmission side coaxial cable shield 11 can be fixed to the outside shield 57 of the shield housing 51 a through the fixing member 9, and the operability of the fixing operation can be improved.

Thus, because the operability of connecting the coaxial connector 3 is improved, and the operability of fixing the transmission side coaxial cable shield 11 is improved, the operability when the coaxial connector 3 is connected to the relay connector 41, and the transmission side coaxial cable shield 11 is fixed to the outside shield 57 can be improved.

Because the fixing member 9 is provided with the protective cover 14 which has electrically insulative property and waterproofness, and the protective cover 14 is bent with the slide of the annular member 8, the fixing member 9 can be electrically insulated from the outside and water can be prevented from invading from the outside.

Because the fixing member 9 is provided with the locking part 9a which is locked to the protective cover 14, and the protective cover 14 is configured so as to be attachable to and detachable from the locking part 9a, when the transmission side coaxial cable shield 11 is fixed to the outside shield 57 of the shield housing 51 a through the fixing member 9, it is possible to remove the protective cover 14 to fix the fixing member 9 and the outside shield 57 of the shield housing 51 a, and the protective cover 14 can be attached to the fixing member 9 after the fixing operation is completed. Therefore, an operability drop of the operation of fixing the fixing member 9 can be prevented.

Because the connector 1 is connected to the relay connector 41 by the fixing structure of the above-mentioned coaxial connector 3, while the operability of connecting the coaxial connector 3 can be improved, the operability of fixing the transmission side coaxial cable shield 11 can be improved and the operability when the connector 1 is connected and fixed to the relay connector 41 can be improved.

Because the connector 1 according to the above embodiment is not limited to be used for the previously described resonance-type contactless power supply system 50, a well-known electrical connecting part or electric wire can be adopted, and the connector 1 can be used to fix various kinds of electrical connecting parts.

For the connector 1 according to the above embodiment, because the transmission side coaxial cable shield 11 may electrically connect the housing shield 52a of the high frequency power source 52 and the outside shield 57 of the transmission coil part 51, the transmission side coaxial cable shield 11 may be, for example, a conductive member such as a conductor pipe or a cylinder which has conductivity.

The corrugated tube 6, as the protector which the transmission side transmission cable 4 is provided with, may be, for example, a pipe made of insulative synthetic resin such as vinyl chloride resin.

The features of the structure for fixing the electrical connection section, the connector, and the connector connecting method according to the embodiment of the present invention described above are briefly, collectively listed in the following [1] to [5], respectively.

[1] A structure for fixing an electrical connection section which connects and fixes a coaxial connector (3) of a shielded transmission side coaxial cable (22) to a relay connector (41) of a shield housing (51 a), the structure including:
   an electrically insulative annular member (8) which is provided slidably along the outer peripheral surface of the coaxial connector (3);
   a conductive fixing member (9) which is provided on the outer peripheral surface of the annular member (8) and is fixed to the shield housing (51 a); and
   a transmission side coaxial cable shield (11) which covers the transmission side coaxial cable (22), and is mechanically and electrically connected to the fixing member (9), wherein
   the transmission side coaxial cable shield (11) is bent with sliding of the annular member (8).
[2] The structure for fixing the electrical connection section as recorded in the above [1], wherein the fixing member (9) is provided with a protective cover (14) which is electrically insulative and waterproof, and
   the protective cover (14) is bent with sliding of the annular member (8).
[3] The structure for fixing the electrical connection section as recorded in the above [2], wherein the fixing member (9) is provided with a locking part (9a) which is locked to the protective cover (14), and
   the protective cover (14) is configured to be attachable to and detachable from the locking part (9a).
[4] A connector which is connected to another electrical connection section by the structure for fixing the electrical connection section recorded by any one of the above [1] to [3].
[5] A method for connecting a connector, which is used to the connector recorded in the above [4], wherein the annular member (8) is slid towards the longitudinally intermediate part of the electric wire so that the transmission side coaxial cable shield (11) is bent and the coaxial connector (3) is projected,
   the coaxial connector (3) of the shielded transmission side coaxial cable (22) is fitted and mechanically and electrically connected to the relay connector (41) of the shield housing (51 a),
   the annular member (8) is slid towards the end of the coaxial connector (3) of the shielded transmission side coaxial cable (22) so that the transmission side coaxial cable shield (11) is restored to an initial shape, and
   the fixing member (9) is mechanically and electrically connected and fixed to the shield housing (51 a).

### (Second embodiment)

The present invention relates to a connector, particularly to a connector for a two-layer coaxial wire which has an inside shielding layer and an outside shielding layer.

First, the background art of the second embodiment of the present invention is described. A technique to supply electric power to a load device by a contactless system is known. As a product into which the technique is applied, a mobile phone charging system has become popular in general. Furthermore, in recent years, the contactless charging system is practically used even as a system to charge electric cars, and various standards are established.

Among various types of contactless power supply systems, one type of charging system for electric cars, which greatly attracts attentions, is a resonance type contactless charging system, and the basic principle of the charging system is developed and demonstrated by MIT (Massachusetts Institute of Technology) (for example, refer to a patent document: Patent Publication No. 2009-501510).

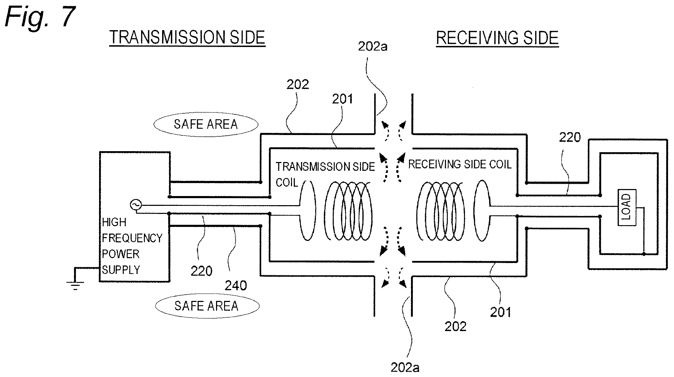

Furthermore, various techniques for practical implementation are suggested. For example, Fig 7 shows a technique to reduce the unnecessary emission electromagnetic field in the resonance-type contactless power supply system. Specifically, in this technique, transmission side and receiving side metal cases (inside shielding cases 201) are covered with metal shields (outside shielding cases 202) which are bigger than the transmission side and receiving side metal cases, and shields 202a of large metal plates are provided in the strong electromagnetic field area between the resonance coils. Coaxial wires 220 are covered with metal shields 240, and the metal shields 240 are connected to the big metal shields (the outside shielding cases 202). By such a construction, a two-layer shield structure to connect the metal shield 240 which covers the coaxial wire 220 to the housing of the high frequency power source is implemented. For this construction, in the connector part where a device such as a unit coil or a power source device and the transmission wire (coaxial wire 220) are connected, it is necessary to perform a shield connecting operation while the two-layer structure is secured. More specifically, the outside conductor (web layer) of the coaxial wire 220 which is connected to the inside shielding case 201 is insulated from the outside shielding layer which is constructed of web wire which is connected to the outside shielding case 202. The outside shield structure is so connected that the inside shield structure is completely covered, except the opening of the coil.

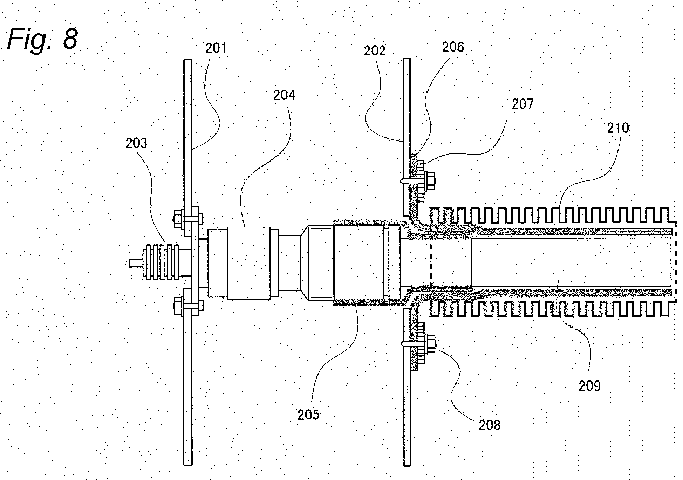

For the connector part, for example, a connecting structure as shown in Fig. 8 is used as a structure to perform the shield connecting operation while the two-layer structure is secured. Since the coaxial connector must be attached from the inside of the outside shielding case 202, but the outside shielding layer (web wire or the like) must be connected with the outside shielding case 202 by fastening brackets 207 from the outside, improvement is needed in terms of operability. Specifically, as shown in the figure, to connect the outside shield member 206 and the outside shielding case 202, the shield member is bended to expand radially to be sandwiched by the outside shielding case 202 and the fastening brackets 207, and fastened with fixing bolts 208, so that while conduction is obtained and electromagnetic field shielding is ensured. At this time, it is necessary to perform an operation of processing the outside shielding layer at a setting place, and it is not easy to perform the operation. It is necessary to perform the connection of the coaxial connector 203 which is attached to the inside shielding case 201 with the cable side coaxial connector 204 at the inside of the outside shielding case 202, it is difficult to perform the operation of connecting the outside shield member 206, which is an operation at the outside, at the same time, and the operations are complicated.

The invention is made in view of the above situation.

Below, the second embodiment to carry out the invention (hereinafter referred to as "the embodiment") is explained with reference to the figures.

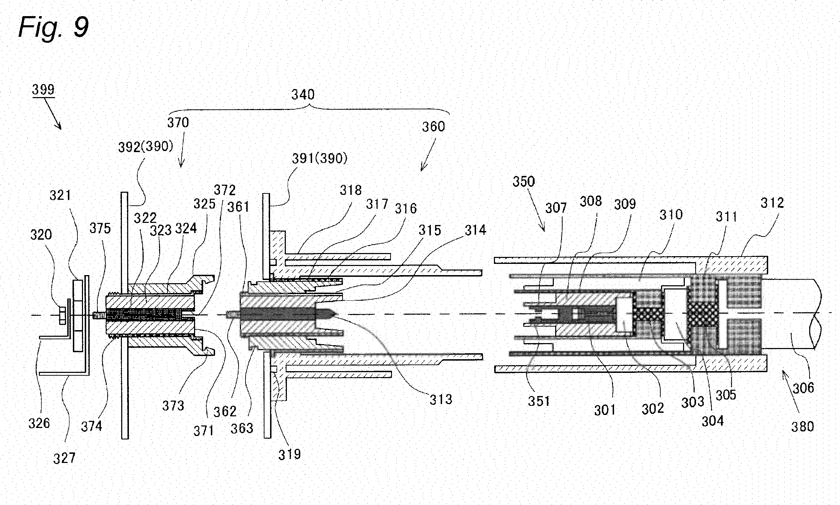

Fig. 9 shows a connecting structure 399 according to the embodiment in which a transmission wire (coaxial wire 380) and connectors (340, 350) are connected, and shows the internal structure clearly here. The connector used for this connecting structure 399 includes a unit side connector 340 which is at the coil side and a cable side connector 350 to which the transmission wire is connected. The unit side connector 340 includes an outside unit side connector 360 and an inside unit side connector 370.

The coaxial wire 380 of a two-layer structure is used as the transmission wire. The coaxial wire 380 has a structure of two shielding layers (web layer or the like) for which insulation are realized inside and outside, respectively. Specifically, as shown in the figure, the coaxial wire 380 includes a coaxial wire inner conductor 301, a coaxial wire inner insulator 302, a coaxial wire intermediate conductor (inside shielding layer) 303, a coaxial wire outer insulator 304, a coaxial wire outer conductor (outside shielding layer) 305, and a coaxial wire sheath 306, from the central side towards the outside. When the coaxial wire 380 is to be connected with the cable side connector 350, the terminal of the coaxial wire 380 is so processed that the members are exposed as desired.

To perform the shielding while the two-layer structure is secured, the cable side connector 350 has a pipe-like structure corresponding to the coaxial wire 380 of the above two shielding layers structure. Specifically, the cable side connector 350 includes an inner conductor 307, an inner insulator 308, an intermediate conductor 309, an outer insulator 310, an outer conductor 311 and a housing 312, from the central side towards the outside.

The inner conductor 307 which is provided at the axis center is connected to the coaxial wire inner conductor 301 of the coaxial wire 380. The terminal, at the side of the unit side connector 340 (left side in the figure), of the inner conductor 307 is formed with a fitting part 351 into which an inner conductor 313 of the unit side connector 340 is inserted to be connected when the unit side connector 340 is connected. The inner insulator 308 covers the inner conductor 307 with a predetermined thickness and secures the insulation between the inner conductor 307 and the intermediate conductor 309. The intermediate conductor 309 is connected to the coaxial wire intermediate conductor 303 by being crimped. The outer insulator 310 covers the intermediate conductor 309 with a predetermined thickness and secures the insulation from the outer conductor 311. The outer conductor 311 is connected to the coaxial wire outer conductor 305 by being crimped. At this time, when the outer conductor 311 is crimped, the coaxial wire sheath 306 is also fixed.

By such a structure and connection, the cable side connector 350 to which the coaxial wire 380 is connected also has a two-layer coaxial structure which the structure of the coaxial wire 380 follows substantially.

The unit side connector 340, which is engaged with and connected to the cable side connector 350, also has a two-layer coaxial structure. The unit side connector 340 includes two units which are an outside unit side connector 360 and an inside unit side connector 370. The outside unit side connector 360 is engaged with the cable side connector 350 and is fixed to an outside shielding case 391. The inside unit side connector 370 is connected to an inner coil and is connected to an inside shielding case 392.

Specifically, the outside unit side connector 360 has the inner conductor 313, an inner insulator 314, an intermediate conductor 315, an outer insulator 316, an outer conductor 317, a housing 318, and a waterproofing ring 319. The outside unit side connector 360 further has male threads 361, 362 and a locking groove 363.

The inside unit side connector 370 has an inner conductor retaining nut 320, an intermediate conductor retaining nut 321, an inner conductor 322, an inner insulator 323, an intermediate conductor 324, a housing 325, an inner conductor connector 326, and an intermediate conductor connector 327. Furthermore, the inside unit side connector 370 includes a fitting part 371, a female thread 372, a locking piece 373 and a male thread 374.

The outer conductor 317 of the outside unit side connector 360 and the outside shielding case 391 are connected to form an outside shielding layer. Further, the intermediate conductor 324 of the inside unit side connector 370 and the inside shielding case 392 are connected to form an inside shielding layer.

To be connected with the coil or the like, the inner conductor 322 and the intermediate conductor 324 are cut with threads so that a round terminal or a bus bar terminal part (equivalent to the inner conductor connector 326 and the intermediate conductor connector 327) can be directly fixed.

Like the inside unit side connector 370, the inner conductor 313 and the intermediate conductor 315 of the outside unit side connector 360 can fix a round terminal or a bus bar terminal, and when the inside shielding case 392 does not exist, the round terminal or the bus bar terminal can be used.

The other end of the inside unit side connector 370 can be directly connected to the outside unit side connector 360, for example, by screwing, and the inner conductor 313 and the inner conductor 322 and the intermediate conductor 315 and the intermediate conductor 324 are electrically connected, respectively. The interval between the inside shielding case 392 and the outside shielding case 391 often varies for each unit. Thus, the length of the inside unit side connector 370can be changed to cope with each unit.

For each of the unit side connector 340 (the outside unit side connector 360 and the inside unit side connector 370) and the cable side connector 350, the inner conductor, the intermediate conductor and the outer conductor are insulated from each other, and characteristic impedances as a coaxial connector are desirably secured.

It becomes possible to connect three poles of the outside unit side connector 360 and the cable side connector 350 at the same time by one operation, and the locking mechanism (the locking piece 373 / the locking groove 363) and the waterproofing mechanism (waterproofing ring 319) also can be installed.

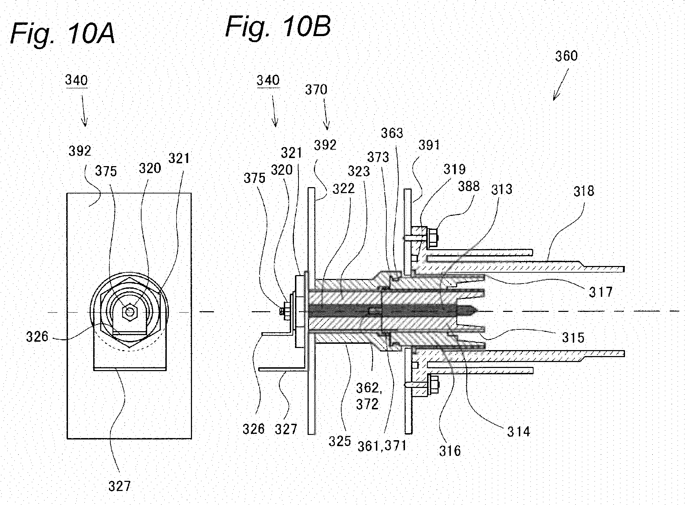

A method of attaching the unit side connector 340 and a connecting method with the internal device (the coil or the like) are shown in Figs. 10A and 10B. The unit side connector 340 is inserted into the mounting hole of the outside shielding case 391, and fixed to the outside shielding case 391 by using bolts 388. Here, the mounting bolts 388 are used, but when waterproofing performance is emphasized, the following fixing method may be used. Stud bolts are raised from the outside shielding case 391, and the outside unit side connector 360 is fitted and fixed with nuts. By such a mounting operation, the outer conductor 311 which is a shield and the outside shielding case 391 contact electrically, and the outside shielding layer is formed.

The inside unit side connector 370, which is connected to the outside unit side connector 360, is inserted into the mounting hole of the inside shielding case 392, and fixed by the intermediate conductor retaining nut 321. The male thread 374 is formed on the surface (outer peripheral surface near the end) of the intermediate conductor 324, and by tightening the intermediate conductor retaining nut 321, the inside shielding case 392 is sandwiched to secure the fixation and the conduction of the connector, and the inside shielding layer is formed. Here, the thread is used to fix the connector, but the connector may be fixed by a fixing locking structure such as a fitting structure.

When the internal device (for example, the coil), which is placed inside the inside shielding case 392, is connected, the inner conductor connector 326 is inserted through a male thread 375 at the distal end of the inner conductor 322 of the inside unit side connector 370, and the conduction is obtained by using the inner conductor retaining nut 320. The conduction of the other pole is obtained by holding the intermediate conductor connector 327 between the above intermediate conductor retaining nut 321 and the intermediate conductor 324 when the intermediate conductor retaining nut 321 and the intermediate conductor 324 are tightened. The inner conductor connector 326 and the intermediate conductor connector 327 can be directly attached to a bus-bar-like conductor which is a part of the coil or the like.

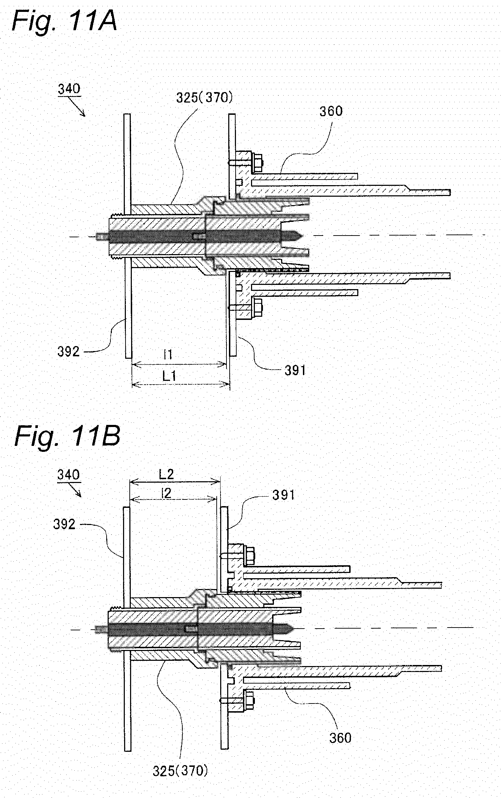

Methods of connecting the unit side connector 340, that is, structures of fixing the outside unit side connector 360 and the inside unit side connector 370 are shown in Figs. 11A and 11B. Fig. 11A is different from Fig. 11B in that the length of the inside unit side connector 370 varies (L1 > L2). The outside unit side connector 360 is so formed that the cable side connector 350 engages from the right side in the figure. As an example of the connecting methods, in the outside unit side connector 360, the front end of the inner conductor 313 is provided with a male thread 362 around M3. Further, in the inside unit side connector 370, the left side end (the side to which the outside unit side connector 360 is connected) of the inner conductor 322 is provided with the female thread 372. The outside unit side connector 360 is screwed into the inside unit side connector 370 to be connected. At this time, the two intermediate conductors 315, 324 of the outside unit side connector 360 and the inside unit side connector 370, 324 are contacted, and a bipolar connection (the inner conductors and the intermediate conductors) is enabled. As connecting methods, as shown in the figure, there are the screwing method for which the intermediate conductor is formed with the thread, and the locking method for which the outer insulator is provided with the fixing locking mechanisms (363, 373). Both structures are shown in the figure, but only either method is enough.

The interval between the inside shielding case 392 and the outside shielding case 391 may vary according to the formation and structure of the unit. For example, the interval L2 (<L1) in Fig. 11B is slightly shorter than the interval L1 in Fig. 11A Accordingly, the change of the length of the inside unit side connector 370 can be coped with. Here, the length l2 (<l1) of the housing 325 of Fig. 11B is shorter than the length l1 of the housing 325 of Fig. 11A.

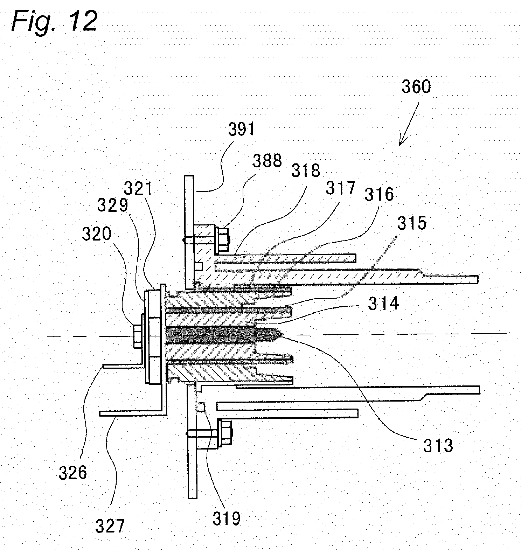

A method of attaching the unit side connector 340 while the shielding case 390 only includes one layer is shown in Fig. 12. For example, when it is assumed that the transmission wire (the coaxial wire 380) is connected to the high frequency power source of Fig. 7, and the shielding case 390 has one layer, it is also possible to use the outside unit side connector 360 only.

Because the front end of the inner conductor 313 of the outside unit side connector 360 is provided with the male thread 362, the inner conductor 313 can be directly fixed and connected to the inner conductor connector 326 by the inner conductor retaining nut 320. When the intermediate conductor connector 327 is attached by using the intermediate conductor retaining nut 321, it can be ensured that the intermediate conductor connector 327 and the intermediate conductor 324 contact and are electrically connected through the intermediate conductor retaining nut 321. Since an insulation board 329 is put between the inner conductor connector 326 and the intermediate conductor retaining nut 321, the insulation between the inner conductor connector 326 and the intermediate conductor connector 327 can be ensured.

According to the present embodiment, the two-layer shielding structure can be implemented effectively by the two-layer shield coaxial connectors (the unit side connector 340 and the cable side connector 350) including a housing which accommodates the inner conductors, the intermediate conductors (shields), the outer conductors (shields) and the insulation structures between these conductors. Particularly, the processability in the setting place can be considerably improved. Furthermore, due to the integral connector structure, the operation of connecting the connectors becomes easy. Even for the unit for which the interval between the inside shielding case 392 and the outside shielding case 391 varies, the outside unit side connector 360 whose structure is very complex can be shared by preparing and setting the length of the inside unit side connector 370 to be different. For the unit for which the outside shielding case 391 and the inside shielding case 392 are integrated, it is also possible to connect the outside unit side connector 360 only.

The present invention is described based on the embodiment as above. The embodiment is illustrative and it is understood by those skilled in the art that it is possible to make various modifications to those components and their combination and that these modifications are also in the scope of the invention.

Here, the features of the connector according to the embodiment of the present invention described above are briefly, collectively listed in the following [6], respectively.
[6] A connector which has a cable side connector (350) which is connected to a two-layer coaxial wire (380) having an inside shielding layer (303) and an outside shielding layer (305) while the coaxial structure is maintained, and a unit side connector (340) which is connected to the cable side connector (350) while the coaxial structure is maintained and which is connected to a unit which has a shielded structure, wherein
   the unit side connector (340) includes
   an outside unit side connector (360), which electrically connects the outside shielding layer (305) to an outside shielding case (391), and which is connected to the cable side connector (350), and
   an inside unit side connector (370) which electrically connects the inside shielding layer (303) to an inside shielding case (392), which is connected to the outside unit side connector (360), and which is able to be connected to internal device which is placed inside the inside shielding case (392) so as to be electrically connected to a coaxial wire inner conductor (301) of the coaxial wire (380).

### (Third embodiment)

The present invention relates to a connector, particularly to a connector for a two-layer coaxial wire which has an inside shielding layer and an outside shielding layer.

First, the background art of the second embodiment of the present invention is described. A technique to supply electric power to a load device by a contactless system is known. As a product into which the technique is applied, a mobile phone charging system has become popular in general. Furthermore, in recent years, the contactless charging system is practically used even as a system to charge electric cars, and various standards are established.

Among various types of contactless power supply systems, one type of charging system for electric cars, which greatly attracts attentions, is a resonance type contactless charging system, and the basic principle of the charging system is developed and demonstrated by MIT (Massachusetts Institute of Technology) (for example, refer to a patent document: Patent Publication No. 2009-501510).

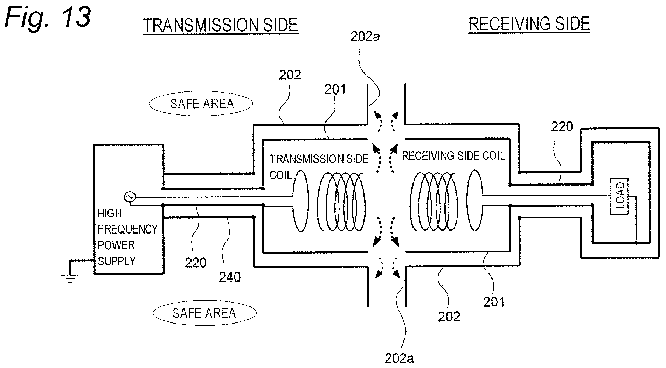

Furthermore, various techniques for practical implementation are suggested. For example, Fig 13 shows a technique to reduce the unnecessary emission electromagnetic field in the resonance-type contactless power supply system. Specifically, in this technique, transmission side and receiving side metal cases (inside shielding cases 201) are covered with metal shields (outside shielding cases 202) which are bigger than the transmission side and receiving side metal cases, and shields 202a of large metal plates are provided in the strong electromagnetic field area between the resonance coils. Coaxial wires 220 are covered with metal shields 240, and the metal shields 240 are connected to the big metal shields (the outside shielding cases 202). By such a construction, a two-layer shield structure to connect the metal shield 240 which covers the coaxial wire 220 to the housing of the high frequency power source is implemented. For this construction, in the connector part where a device such as a unit coil or a power source device and the transmission wire (coaxial wire 220) are connected, it is necessary to perform a shield connecting operation while the two-layer structure is secured. More specifically, the outside conductor (web layer) of the coaxial wire 220 which is connected to the inside shielding case 201 is insulated from the outside shielding layer which is constructed of web wire which is connected to the outside shielding case 202. The outside shield structure is so connected that the inside shield structure is completely covered, except the opening of the coil.

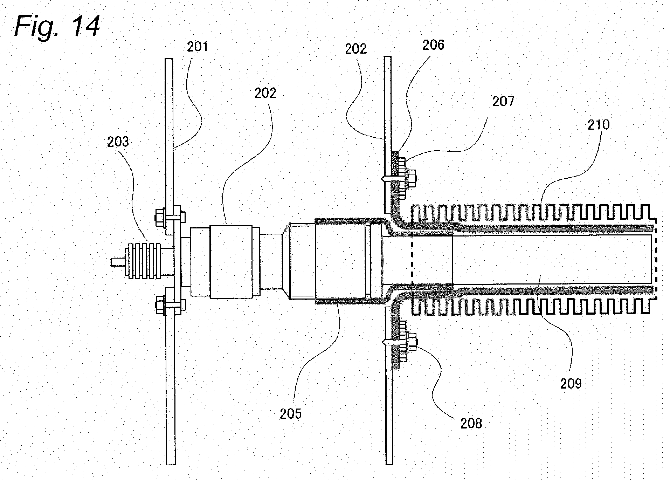

For the connector part, for example, a connecting structure as shown in Fig. 14 is used as a structure to perform the shield connecting operation while the two-layer structure is secured. Since the coaxial connector must be attached from the inside of the outside shielding case 202, but the outside shielding layer (web wire or the like) must be connected with the outside shielding case 202 by fastening brackets 207 from the outside, improvement is needed in terms of operability. Specifically, as shown in the figure, to connect the outside shield member 206 and the outside shielding case 202, the shield member is bended to expand radially to be sandwiched by the outside shielding case 202 and the fastening brackets 207, and fastened with fixing bolts 208, so that while conduction is obtained and electromagnetic field shielding is ensured. At this time, it is necessary to perform an operation of processing the outside shielding layer at a setting place, and it is not easy to perform the operation. It is necessary to perform the connection of the coaxial connector 203 which is attached to the inside shielding case 201 with the cable side coaxial connector 204 at the inside of the outside shielding case 202, it is difficult to perform the operation of connecting the outside shield member 206, which is an operation at the outside, at the same time, and the operations are complicated.

The invention is made in view of the above situation.

Below, the third embodiment to carry out the invention (hereinafter referred to as "the embodiment") is explained with reference to the figures.

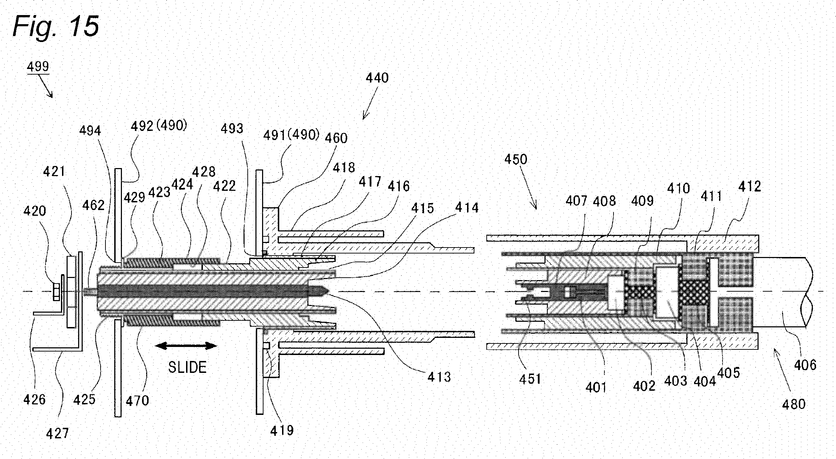

Fig. 15 shows a connecting structure 499 according to the embodiment in which a transmission wire (coaxial wire 480) and a unit side connector 440 are connected, and shows the internal structure clearly here. This connecting structure 499 includes the unit side connector 440 which is connected to the coil (internal device) side which is placed inside the shielding case, and a cable side connector 450 to which the transmission wire is connected. The internal device that is connected with the unit side connector 440 is covered with a two-layer shielding structure (an outside shielding case 491 and an inside shielding case 492) like the structure shown in Fig. 13.

The coaxial wire 480 of a two-layer laminar structure is used as the transmission wire. The coaxial wire 480 has a structure of two shielding layers (web layer or the like) for which insulation are realized inside and outside, respectively. Specifically, as shown in the figure, the coaxial wire 480 includes a coaxial wire inner conductor 401, a coaxial wire inner insulator 402, a coaxial wire intermediate conductor (inside shielding layer) 403, a coaxial wire outer insulator 404, a coaxial wire outer conductor (outside shielding layer) 405, and a coaxial wire sheath 406, from the central side towards the outside. When the coaxial wire 380 is to be connected with the cable side connector 450, the terminal of the coaxial wire 380 is so processed that the members are exposed as desired.

To perform the shielding while the two-layer structure is secured, the cable side connector 450 has a pipe-like structure corresponding to the coaxial wire 480 of the above two shielding layers structure. Specifically, the cable side connector 450 includes an inner conductor 407, an inner insulator 408, an intermediate conductor 409, an outer insulator 410, an outer conductor 411 and a housing 412, from the central side towards the outside.

The inner conductor 407 which is provided at the axis center is connected to the coaxial wire inner conductor 401 of the coaxial wire 480. The terminal, at the side of the unit side connector 440 (left side in the figure), of the inner conductor 407 is formed with a fitting part 451 into which an inner conductor 413 of the unit side connector 440 is inserted to be connected when the unit side connector 440 is connected. The inner insulator 408 covers the inner conductor 407 with a predetermined thickness and secures the insulation between the inner conductor 407 and the intermediate conductor 409. The intermediate conductor 409 is connected to the coaxial wire intermediate conductor 403 by being crimped. The outer insulator 410 covers the intermediate conductor 409 with a predetermined thickness and secures the insulation from the outer conductor 411. The outer conductor 411 is connected to the coaxial wire outer conductor 405 by being crimped. At this time, when the outer conductor 411 is crimped, the coaxial wire sheath 406 is also fixed.

By such a structure and connection, the cable side connector 450 to which the coaxial wire 480 is connected also has a two-layer coaxial structure which the structure of the coaxial wire 480 follows substantially.

The unit side connector 440, which is engaged with and connected to the cable side connector 450, also has a two-layer coaxial structure. The unit side connector 440 includes a unit side connector body 460 and a sliding unit 470. One end (right end in the figure) side of the unit side connector body 460 engages with the cable side connector 450, and one end of the sliding unit 470 is connected to the coil or the like. Although the details will be described later, the unit side connector body 460 is connected with the outside shielding case 491, and the sliding unit 470 is connected to the inside shielding case 492. Because the sliding unit 470 slides on the outer peripheral surface of the unit side connector body 460, it is possible to cope with the situation that the interval between the outside shielding case 491 and the inside shielding case 492 varies.

Specifically, the unit side connector body 460 is a cylindrical body, and includes an inner conductor 413, an inner insulator 414, an intermediate conductor 415, an outer insulator 416, an outer conductor 417 and a housing 418, from the central side towards the outside.

When the end, at the side of the cable side connector 450, of the inner conductor 413 is inserted into the fitting part 451 of the cable side connector 450 and connected, the inner conductor 407 of the cable side connector 450 (that is, the coaxial wire inner conductor 401) is electrically connected. Here, the end of the inner conductor 413 becomes a conical shape to make it easy to insert. To be connected with the coil or the like, the other end of the inner conductor 413 is formed with a male thread 462, and a round terminal or a bus bar terminal part (inner conductor connector 426) can be directly fixed with an inner conductor retaining nut 420.

The inner insulator 414 is formed to cover the inner conductor 413 and secure the insulation between the inner conductor 413 and the intermediate conductor 415. The intermediate conductor 415 is formed to cover the inner insulator 414, and when the cable side connector 450 is connected, the intermediate conductor 415 is electrically connected with the intermediate conductor 409 of the cable side connector 450. The intermediate conductor 415 is connected to the inside shielding case 492 through an intermediate conductor 423 of the sliding unit 470, and the inside shielding layer is formed.

The outer insulator 416 is formed to cover the intermediate conductor 415. Here, the outer insulator 416 covers about half of the area at the side of the unit side connector 440, and at the about half remaining area at the coil side (the left side in the figure), the intermediate conductor 415 is exposed. The sliding unit 470 abuts against and slides on the exposed outer peripheral surface of the intermediate conductor 415. The end, at the side of the cable side connector 450, of the outer insulator 416 is formed with a concave of such a depth that the intermediate conductor 409 and the outer insulator 410 of the cable side connector 450 can be fitted and connected.

The outer conductor 417 is formed to cover the outer insulator 416, and is connected to the outside shielding case 491 to form the outside shielding layer.

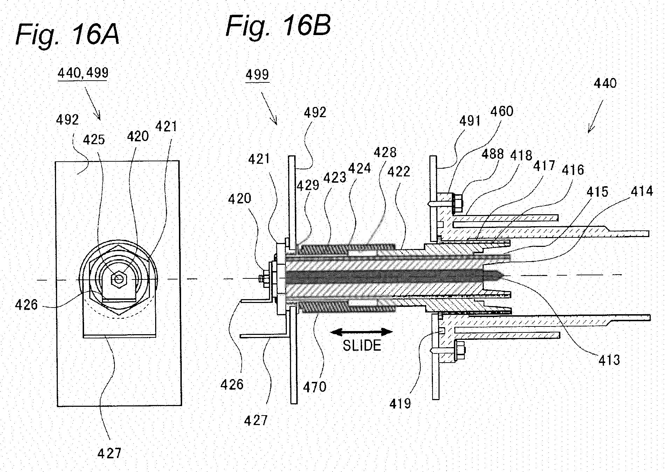

The housing 418 is formed to cover the outer conductor 417 and is formed into a disk form at the left side in the figure. The housing 418 is fixed to the outside shielding case 491 by bolts 488 (refer to Figs. 16A and Fig. 16B) or the like.

In the practical arrangement, since the interval between the outside shielding case 491 and the inside shielding case 492 varies depending on the units, the length of the unit side connector 440 is changed for each unit to cope with the situation. For example, the intermediate conductor 423 of the sliding unit 470 may slide on the surface of intermediate conductor 415 of the unit side connector body 460 until the distal end of the intermediate conductor 423 abuts against the inside shielding case 492 and is fixed.

The sliding unit 470 is a pipe-formed body, and integrally includes the intermediate conductor 423 at the central side and an outer insulator 424 at the outside. The intermediate conductor 423 is exposed at the distal end side (the left side in the figure), and the exposed part of the intermediate conductor 423 is formed with a male thread 425. The root part, at the side of the cable side connector 450, of the male thread 425 is formed with a fastening projection 429. A slide fitting part 428 in which a housing sliding surface 422 can be accommodated is formed at the inner peripheral surface, at the side of the unit side connector body 460, of the outer insulator 424.

To be connected with the coil or the like, the intermediate conductor 423 of the sliding unit 470 is formed with the male thread 425, and a round terminal or a bus bar terminal part (intermediate conductor connector 427) can be directly fixed with an intermediate conductor retaining nut 421.

For each of the unit side connector 440 (the unit side connector body 460 and the sliding unit 470) and the cable side connector 450, even in a connected state, the inner conductor, the intermediate conductor and the outer conductor are insulated from each other, and characteristic impedances as a coaxial connector is desirably secured. That is, when the unit side connector 440 and cable side connector 450 are connected by being fitted, the unit side connector 440 and the cable side connector 450 forms a coaxial structure which follows the coaxial structure of the coaxial wire 480.

It becomes possible to connect the three poles of the unit side connector 440 and the cable side connector 450 at the same time by one operation, and the locking mechanism and the waterproofing mechanism (waterproofing ring 419) also can be installed.

A method of attaching the unit side connector 440 and a connecting method with the internal device (the coil or the like) are shown in Figs. 16A and 16B in detail. Fig. 16A is a figure viewed from the inside of the inside shielding case 492, and Fig. 16B is a figure which shows a section of part of the side surface. The unit side connector 440 has such a shape that the cable side connector 450 engages from the right side in the figure, and the internal device such as the coil is directly or by a round terminal (electric wire connection) connected to the left side end of the unit side connector 440 by, for example, a bus bar.

First, the unit side connector body 460 is inserted into the mounting hole 493 of the outside shielding case 491, and fixed to the outside shielding case 491 by using bolts 488 by being abutted against the end of the housing 418. Here, the mounting bolts 488 are used, but when waterproofing performance is emphasized, the following fixing method may be used. Stud bolts are raised from the outside shielding case 491, and the unit side connector body 460 is fitted and fixed with nuts. By such a mounting operation, the outer conductor 411 which is a shield and the outside shielding case 491 contact electrically, and the outside shielding layer is formed.

Then, by adjusting the sliding unit 470 of the unit side connector 440 to match the interval between the outside shielding case 491 and the inside shielding case 492, the distal end is inserted into the mounting hole 494 of the inside shielding case 492. By fixing and connecting the intermediate conductor connector 427 by using the intermediate conductor retaining nut 421 so that the intermediate conductor 423 of the sliding unit 470 can be connected with the inside shielding case 492, the inside shielding layer is formed.

The internal device such as the coil is connected to the inner conductor 413 of the unit side connector body 460, and, as shown in the figure, the left side end of the inner conductor 413 is formed with the male thread 462 around M3, and the inside conductor connector 426 is fixed by using the inner conductor retaining nut 420, as a connecting method, to obtain conduction. Here, the thread is used to fix the connector, but the connector may be fixed by a fixing locking structure such as a fitting structure.

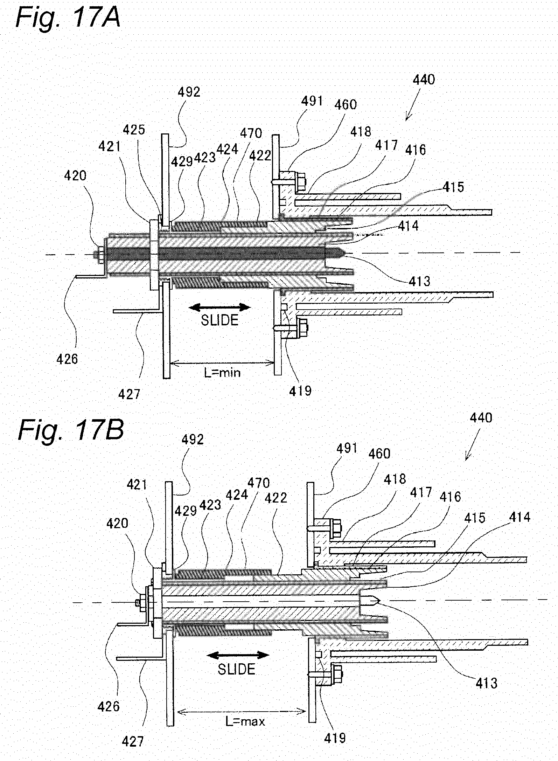

Then, based on Figs. 17A and 17B, the method of connecting the unit side connector 440, that is, a length adjustment structure of the unit side connector 440 with the sliding unit 470 is described. Fig. 17A shows that the interval between the outside shielding case 491 and the inside shielding case 492 becomes shortest, and Fig. 17B shows that the interval between the outside shielding case 491 and the inside shielding case 492 becomes longest.

In the unit side connector 440, the intermediate conductor 423 of the sliding unit 470 is configured so that the intermediate conductor 423 can slide while the contact of the surface of the intermediate conductor 415 of the unit side connector body 460 with the intermediate conductor 423 is maintained. The intermediate conductor 423 and the outer insulator 424 is unified mechanically to construct the sliding unit 470.

By moving the sliding unit 470 to make the length of the unit side connector 440 expand or contract so that the fastening projection 429 of the intermediate conductor 423 abuts against the inside shielding case 492, the interval between the outside shielding case 491 and the inside shielding case 492 is matched.

As described above, the male thread 425 is formed near the distal end of the intermediate conductor 423. By using the male thread 425 to tighten the inside shielding case 492 and the intermediate conductor connector 427 with the intermediate conductor retaining nut 421, the fixation and the electrical connection of the unit side connector 440 and the inside shielding case 492 is secured.

By using the sliding unit 470, in a certain adjustment range, the interval between the outside shielding case 491 and the inside shielding case 492 can be coped with accordingly only by the unit side connector 440.

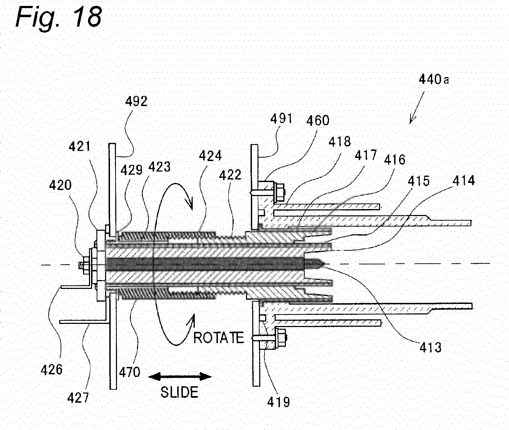

In Fig. 18, a unit side connector 440a which is more strongly attached and fixed than the unit side connector 440 is described as a variation. For the above unit side connector 440, when the outside shielding case 491 and the inside shielding case 492 are fixed strongly, the clearance at the interval between the outside shielding case 491 and the inside shielding case 492 can be absorbed by a slider (the sliding unit 470). However, in some cases, the strength of the inside shielding case 492 makes it hard to maintain a desired low case interval. In this case, the sliding unit 470 becomes always movable, and unnecessary stress may occur.

Thus, as shown in Fig. 18, the housing sliding surface 422 which the outer insulator 416 of the unit side connector body 460 is formed with and the inside surface of the outer insulator 424 of the sliding unit 470 are formed with threads. With the structure shown in the figure, the sliding amount can be adjusted by rotating the sliding unit 470. The length of the unit side connector 440 also can be in a semi-fixed state. As a result, the installation property is improved.

Further, when the intermediate conductor connector 427 is structurally unnecessary, for example, when the single pole of the coil or the like is connected to the inside shielding case 492 elsewhere, the contact of the inside shielding case 492 with the intermediate conductor 423 can be maintained even without the intermediate conductor retaining nut 421.

According to the present embodiment, the two-layer shielding structure can be implemented effectively by the two-layer shield coaxial connectors (the unit side connector 440 and the cable side connector 450) including a housing which accommodates the inner conductor, the intermediate conductor (shield), the outer conductor (shield) and the insulation structures between these conductors. Particularly, the processability in the setting place can be considerably improved. Furthermore, due to the integral connector structure, the operation of connecting the connectors becomes easy. Even for the unit for which the interval between the inside shielding case 492 and the outside shielding case 491 varies, the unit side connector 460 whose structure is very complex can be shared by means of a sliding mechanism (the sliding unit 470).

The present invention is described based on the embodiment as above. The embodiment is illustrative and it is understood by those skilled in the art that it is possible to make various modifications to those components and their combination and that these modifications are also in the scope of the invention.

Here, the features of the connector according to the embodiment of the present invention described above are briefly, collectively listed in the following [7], respectively.
[7] A connector including:
   a cable side connector (450) which is connected to a two-layer coaxial wire (480) having an inside shielding layer (403) and an outside shielding layer (405) while the coaxial structure is maintained; and
   a unit side connector (440) which is connected to the cable side connector (450) while the coaxial structure is maintained and which is connected to a unit which has a shielded structure, wherein
   the unit side connector (440) has a substantially columnar unit side connector body (460) wherein one end of the connector body (460) is connected to the cable side connector (450) and the other end of the connector body (460) is connected to the unit, and a sliding part (470) which covers the outer periphery of the unit side connector body (460) and is arranged movably back and forth in the axial direction,
   the unit side connector body (460) is configured to electrically connect and fix a coaxial wire inner conductor (401), which is electrically connected to the inside shielding layer (403) of the coaxial wire (480), to an inside shielding case (492) which covers the unit, and
   the sliding part (470) includes an intermediate conductor (423) which is electrically connected to an intermediate conductor (415), which is electrically connected to the outside shielding layer (405) of the coaxial wire (480), of the unit side connector body (460) when the sliding part (47) moves, and is configured to electrically connect and fix the intermediate conductor (423) to an outside shielding case (491) which is placed outside the inside shielding case (492).

Although the invention is described in detail with reference to the specific embodiments, it is apparent that various modifications and amendments may be made by those skilled in the art without departing from the scope of the invention.

This application is based on the Japanese patent application (patent application 2011-271843) filed on December 13th, 2011, the Japanese patent application (patent application 2012-54402) filed on March 12th, 2012 and the Japanese patent application (patent application 2012-54437) filed on March 12th, 2012.

### Industrial applicability

According to the present invention, an effect is achieved which is that the connecting operation of connecting an electrical connection section which the terminal of an shielded electric wire is provided with and an electrical connection section which a shielded device is provided with can be improved, and the present invention is useful in an electrical connecting part fixing structure in which connectors are used, and in a connector connecting method.

### Reference Signs List

- 1: connector
- 2: connector fixing device (structure for fixing electrical connection section)
- 3: coaxial connector (electrical connection section of a shielded electric wire)
- 8: annular member
- 9: fixing member
- 9a: locking part
- 11: transmission side coaxial cable shield (shielding member)
- 14: protective cover
- 22: transmission side coaxial cable (electric wire)
- 41: relay connector (electrical connection section of the shield housing)
- 51a: shield housing
- 301: coaxial wire inner conductor
- 302: coaxial wire inner insulator
- 303: coaxial wire intermediate conductor
- 304: coaxial wire outer insulator
- 305: coaxial wire outer conductor
- 306: coaxial wire sheath
- 307, 313, 322: inner conductor
- 308, 314, 323: inner insulator
- 309, 315, 324: intermediate conductor
- 310, 316: outer insulator
- 311, 317: outer conductor
- 312, 318, 325: housing
- 319: waterproofing ring
- 320: inner conductor retaining nut
- 321: intermediate conductor retaining nut
- 326: inner conductor connector
- 327: intermediate conductor connector
- 329: insulation board
- 340: unit side connector
- 350: cable side connector
- 360: outside unit side connector
- 361, 362, 374, 375: male thread
- 363: locking groove
- 370: inside unit side connector
- 371: fitting part
- 372: female thread
- 373: locking piece
- 380: coaxial wire
- 390: shielding case
- 391: outside shielding case
- 392: inside shielding case
- 399: connecting structure
- 401: coaxial wire inner conductor
- 402: coaxial wire inner insulator
- 403: coaxial wire intermediate conductor
- 404: coaxial wire outer insulator
- 405: coaxial wire outer conductor
- 406: coaxial wire sheath
- 407, 413: inner conductor
- 408, 414: inner insulator
- 409: intermediate conductor
- 410, 416, 424: outer insulator
- 411, 417: outer conductor
- 412, 418: housing
- 415: intermediate conductor (body side intermediate conductor)
- 419: waterproofing ring
- 420: inside conductor retaining nut
- 421: intermediate conductor retaining nut
- 422: housing sliding surface
- 423: intermediate conductor (slide side intermediate conductor)
- 425, 462: male thread
- 426: inner conductor connector
- 427: intermediate conductor connector
- 428: slide fitting part
- 429: fastening projection
- 440, 440a: unit side connector
- 450: cable side connector
- 460: unit side connector body
- 470: sliding unit
- 480: coaxial wire
- 490: shielding case
- 491: outside shielding case
- 492: inside shielding case
- 493: mounting hole
- 499: connecting structure

## Claims

1. A structure for fixing an electrical connection section which connects and fixes an electrical connection section (3) of a shielded electric wire (22) to an electrical connection section (41) of a shield housing (51 a), the structure comprising:
an electrically insulative annular member (8) which is provided slidably along an outer peripheral surface of the electrical connection section (3) of the shielded electric wire (22);
a fixing member (9) which is provided on the outer peripheral surface of the annular member (8) and is fixed to the shield housing (51 a); and
a shield member (11) which covers the electric wire (22) and is mechanically connected to the fixing member (9),
**characterized in that**
the fixing member (9) is conductive;
the shield member (11) covers the electric wire (22) and is electrically connected to the fixing member (9), and
the shield member (11) is bent with sliding of the annular member (8).

2. The structure for fixing the electrical connection section according to claim 1, wherein the fixing member (9) is provided with a protective cover (14) which is electrically insulative and waterproof, and
the protective cover (14) is bent with sliding of the annular member (8).

3. The structure for fixing the electrical connection section according to claim 2, wherein the fixing member (9) is provided with a locking part (9a) which is locked to the protective cover (14), and
the protective cover (14) is configured to be attachable to and detachable from the locking part (9a).

4. An assembly comprising the structure for fixing an electrical connection section according to any one of the claims 1 to 3 and a connector connected to the electrical connection section by said structure.

5. A method for connecting a connector, which is used in a assembly according to claim 4, wherein
the annular member (8) is slid towards a longitudinally intermediate part of the electric wire (22) so that the shield member (11) is bent and the electrical connection section (3) is projected,
the electrical connection section (3) of the shielded electric wire (22) is fitted and mechanically and electrically connected to the electrical connection section (41) of the shield housing (51 a),
the annular member (8) is slid towards an end of the electrical connection section (3) of the shielded electric wire (22) so that the shield member (11) is restored to an initial shape, and
the fixing member (9) is mechanically and electrically connected and fixed to the shield housing (51 a).

## Patentansprüche

1. Eine Befestigungsstruktur für einen elektrischen Verbindungsabschnitt, die einen elektrischen Verbindungsabschnitt (3) eines abgeschirmten elektrischen Kabels (22) mit einem elektrischen Verbindungsabschnitt (41) eines Schirmgehäuses (51a) verbindet und befestigt, die Struktur umfasst:
ein elektrisch isolierendes ringförmiges Teil (8), welches entlang einer äußeren Umfangsfläche des elektrischen Verbindungsabschnitts (3) des abgeschirmten elektrischen Kabels (22) verschiebbar vorgesehen ist;
ein Befestigungsteil (9), welches an der äußeren Umfangsfläche des ringförmigen Teils (8) vorgesehen ist und mit dem Schirmgehäuse (51 a) befestigt ist; und
ein Schirmteil (11), welches das elektrische Kabel (22) abdeckt und mechanisch mit dem Befestigungsteil (9) verbunden ist,
**dadurch gekennzeichnet, dass**
das Befestigungsteil (9) leitfähig ist;
das Schirmteil (11) das elektrische Kabel (22) abdeckt und elektrisch mit dem Befestigungsteil (9) verbunden ist, und
das Schirmteil (11) mit Verschieben des ringförmigen Teils (8) verbogen ist.

2. Die Befestigungsstruktur für einen elektrischen Verbindungsabschnitt nach Anspruch 1, wobei das Befestigungsteil (9) mit einer Schutz-Abdeckung (14) vorgesehen ist, welche elektrisch isolierend und wasserdicht ist, und
die Schutz-Abdeckung (14) mit Verschieben des ringförmigen Teils (8) verbogen ist.

3. Die Befestigungsstruktur für einen elektrischen Verbindungsabschnitt nach Anspruch 2, wobei das Befestigungsteil (9) mit einem Verriegelungsteil (9a) vorgesehen ist, welches mit der Schutz-Abdeckung (14) verriegelt ist, und
die Schutz-Abdeckung (14) konfiguriert ist, um an den Verriegelungsteil (9a) ansteckbar und von dem Verriegelungsteil (9a) abnehmbar zu sein.

4. Eine Baugruppe umfasst die Befestigungsstruktur für einen elektrischen
Verbindungsabschnitt nach einem der Ansprüche 1 bis 3 und einen Verbinder, der mit dem elektrischen Verbindungsabschnitt durch die Struktur verbunden ist.

5. Ein Verfahren zum Anschluss eines Verbinders, welches in einer Baugruppe nach Anspruch 4 verwendet wird, wobei das ringförmige Teil (8) in Richtung eines longitudinalen Zwischenbauteils eines elektrischen Kabels (22) geschoben wird, so dass das Schirmteil (11) gebogen wird und der elektrische Verbindungsabschnitt (3) hervorstehen wird,
der elektrische Verbindungsabschnitt (3) des elektrischen Kabels (22) wird aufgesetzt und mechanisch und elektrisch mit dem elektrischen Verbindungsabschnitt (41) des Schirmgehäuses (51 a) verbunden,
das ringförmige Teil (8) wird in Richtung eines Endes des elektrischen Verbindungsabschnitts (3) des abgeschirmten elektrischen Kabels (22) geschoben, so dass das Schirmteil (11) in eine Ausgangsform zurückgeführt wird, und
das Befestigungsteil (9) mechanisch und elektrisch mit dem Schirmgehäuse (51 a) befestigt wird.

## Revendications

1. Structure pour fixer une section de connexion électrique qui connecte et fixe une section de connexion électrique (3) d'un fil électrique blindé (22) à une section de connexion électrique (41) d'un boîtier de blindage (51a), la structure comprenant :
un élément annulaire électriquement isolant (8) qui est disposé de manière coulissante le long d'une surface périphérique extérieure de la section de connexion électrique (3) du fil électrique blindé (22) ;
un élément de fixation (9) qui est disposé sur la paroi périphérique extérieure de l'élément annulaire (8) et est fixé au boîtier de blindage (51a) ; et
un élément de blindage (11) qui recouvre le fil électrique (22) et est mécaniquement connecté à l'élément de fixation (9),
**caractérisée en ce que**
l'élément de fixation (9) est conducteur ;
l'élément de blindage (11) recouvre le fil électrique (22) et est électriquement connecté à l'élément de fixation (9), et
l'élément de blindage (11) est fléchi par le coulissement de l'élément annulaire (8).

2. Structure pour fixer la section de connexion électrique selon la revendication 1, où
l'élément de fixation (9) est pourvu d'un couvercle de protection (14) qui est électriquement isolant et étanche à l'eau, et
le couvercle de protection (14) est fléchi par le coulissement de l'élément annulaire (8).

3. Structure pour fixer la section de connexion électrique selon la revendication 2, où
l'élément de fixation (9) est pourvu d'une partie de verrouillage (9a) qui est verrouillée au couvercle de protection (14), et
le couvercle de protection (14) est configuré pour pouvoir être attaché et détaché de la partie de verrouillage (9a).

4. Ensemble comprenant la structure pour fixer une section de connexion électrique selon l'une quelconque des revendications 1 à 3 et connecteur connecté à la section de connexion électrique par ladite structure.

5. Procédé pour connecter un connecteur utilisé dans un ensemble selon la revendication 4, lors duquel
l'élément annulaire (8) est coulissé en direction d'une partie intermédiaire longitudinale du fil électrique (22) de manière à fléchir l'élément de blindage (11) et à projeter la section de connexion électrique (3),
la section de connexion électrique (3) du fil électrique blindé (22) est installée et mécaniquement et électriquement connectée à la section de connexion électrique (41) du boîtier de blindage (51a),
l'élément annulaire (8) est coulissé vers une extrémité de la section de connexion électrique (3) du fil électrique blindé (22), de sorte que l'élément de blindage (11) retrouve une forme initiale, et
l'élément de fixation (9) est mécaniquement et électriquement connecté et fixé au boîtier de blindage (51a).
